# EUROPÄISCHE PATENTSCHRIFT

(11) **EP 0 788 673 B1**
(45) Veröffentlichungstag und Bekanntmachung des Hinweises auf die Patenterteilung: **02.04.2003**
(21) Anmeldenummer: 95936557.8
(22) Anmeldetag: 26.10.1995
(51) Int. Cl.: H01S 5/00, H01S 5/40, H01S 5/026, G02B 27/09, G02B 27/14

(54) **ANORDNUNG ZUR FÜHRUNG UND FORMUNG VON STRAHLEN EINES GERADLINIGEN LASERDIODENARRAYS**
ARRANGEMENT FOR GUIDING AND SHAPING BEAMS FROM A RECTILINEAR LASER DIODE ARRAY
DISPOSITIF DE GUIDAGE ET DE FACONNAGE DES FAISCEAUX EMIS PAR UNE RANGEE RECTILIGNE DE DIODES LASER

(30) Priorität: 27.10.1994 DE 4438368
(43) Veröffentlichungstag der Anmeldung: 13.08.1997
(73) Patentinhaber: FRAUNHOFER-GESELLSCHAFT ZUR FÖRDERUNG DER ANGEWANDTEN FORSCHUNG E.V., 80636 München (DE)
(72) Erfinder: DU, Keming, D-52078 Aachen (DE); LOOSEN, Peter, D-52076 Kornelimünster (DE)
(74) Vertreter: Grimm, Ekkehard, Dipl.-Phys.
(86) Internationale Anmeldenummer: EP9504215
(87) Internationale Veröffentlichungsnummer: WO96013884

(56) Entgegenhaltungen:
- EP-A- 0 569 181
- WO-A-95/15510
- US-A- 4 128 308
- US-A- 4 725 131
- US-A- 4 763 975
- US-A- 4 921 338
- US-A- 4 986 634
- US-A- 5 268 978
- PROCEEDINGS OF THE CONFERENCE ON LASERS AND ELECTRO-OPTICS EUROPE (CLEO/EUROPE), AMSTERDAM, AUG. 28 - SEPT. 2, 1994, Nr. -, 28.August 1994 INSTITUTE OF ELECTRICAL AND ELECTRONICS ENGINEERS, Seite 410/411 XP 000475367 CLARKSON W A ET AL 'DIODE LASER BAR BEAM SHAPING TECHNIQUE'
- OPTICS LETTERS, Bd. 20, Nr. 2, 15.Januar 1995 Seiten 222-224, XP 000486652 EDWIN R P 'STRIPE STACKER FOR USE WITH LASER DIODE BARS'

## Beschreibung

Die vorliegende Erfindung betrifft eine Anordnung zur Formung und Führung von Strahlen eines geradlinigen Laserdiodenarrays mit in einer gemeinsamen Ebene liegenden Strahlaustrittsflächen mittels einer Reflexionsoptik, wobei die Ebene parallel zu der xy-Ebene liegt und die x-Achse parallel zu dem pn-Übergang der Laserdioden des Arrays liegt und wobei die Abstrahlrichtung der Laserdioden parallel zu der z-Achse liegt, wobei x, y und z ein rechtwinkliges Koordinatensystem bilden, wobei jedem Austrittsstrahl mindestens ein erstes Reflexionselement mit einer Reflexionsfläche zugeordnet ist und die Reflexionsflächen in Ebenen angeordnet sind, die einen Versatz zueinander aufweisen, der sequentiell der Reihenfolge der Laserdioden des Arrays entspricht, wobei die Reflexionsflächen jeweils einen unterschiedlichen Abstand zu den ihnen zugeordneten Strahlaustrittsflächen aufweisen, und wobei die Reflexionsflächen durch einen treppenartigen Spiegel gebildet sind.

Eine derartige Anordnung ist aus der US-A-4,986,634 bekannt.

Durch die schnelle Weiterentwicklung der Hochleistungsdiodenlasertechnologie in den letzten Jahren werden vielseitige Anwendungen von Diodenlasern erschlossen. Von diesen ist z.B. das Pumpen von Festkörperlasern mittels Laserdioden zu nennen.

Eine besondere Eigenart von Diodenlasern ist der asymmetrische Querscnnitt des Ausgangsstranis, der aus der emittierenden Zone bzw. der Austrittsfläche austritt. Dieser Strahl besitzt eine im Querschnitt charakteristische, elliptische Form. Die große Achse dieses ellipsenförmigen Querschnitts verläuft senkrecht zu dem pn-Übergang der Diodenstruktur (auch als Fast-Richtung bezeichnet), während die kleine Achse parallel zu der Ebene des pn-Übergangs (auch als Slow-Richtung bezeichnet) verläuft. Zu diesem asymmetrischen Strahlquerschnitt kommt hinzu, daß die austretende Strahlung in Richtung der großen Achse, d.h. senkrecht zu der Ebene des pn-Übergangs bzw. zu der aktiven Schicht, eine hohe Divergenz zeigt, mit einer Strahlöffnung von bis zu 90°, während in der Richtung der kleinen Achse diese Divergenz nur bei etwa 10° liegt.

Aufgrund des besonderen elliptischen Strahlquerschnitts und der großen Divergenz senkrecht zur aktiven Ebene (auch als Junction-Ebene bezeichnet) und einer relativ geringen Divergenz senkrecht dazu hängt der Einsatz solcher Diodenlaser entscheidend von der geeigneten Führung und Formung der Diodenlaserstrahlung ab, insbesondere auch dann, wenn viele solcher Laserdioden zu Laserdiodenfeldern oder -arrays zusammergefaßt werden.

Herkömmlich erfolgt die Führung und Formung der Laserdiodenstrahlung durch transmittive Optiken, wie Linsen und Prismen, die in den Strahlengang des aus der AustrittsÖffnung der Laserdiode austretenden Strahlung eingefügt wird. In bestimmten Anwendungsfällen, beispielsweise in dem Fall des Diodenpumpens von Festkörperlasern, muß die Diodenstrahlung jeder Diode mit einer Linse auf den Festkörperstab fokusiert werden. Problematisch dabei ist es, eine Linse von einer extrem großen numerischen Apertur zu finden, mit der die Diodenstrahlung mit dem vorstahend beschriebenen Divergenzwinkel von etwa 90° in Richtung senkrecht zu der Ebene des pn-Übergangs vollständig erfaßt werden kann. Solche Linsen sind prinzipiell nur aus Glas mit sehr großem Brechungsindex herstellbar. Ein Nachteil ist allerdings der durch die großen Einfallswinkel hervorgerufene Reflexionsverlust in der Linse, der typischerweise höher als 20 % liegt und folglich den hohen Wirkungsgrad, den ein Diodenlaser unter anderem auszeichnet, herabsetzt.

Hochleistungslaserdioden haben typischerweise aktive Medien mit einem Querschnitt von 1 x 100 µm. Weiterhin werden aus Kostengründen mehrere Laserdioden mit ihren Strahlaustrittsflächen nebeneinander oder in komplexen Feldern bzw. Arrays angeordnet. Zur Erzeugung von Strahlenfeldern sind hierbei Laserdioden, sofern sie in einer Reihe angeordnet sind, mit der großen Achse ihres elliptischen Strahlquerschnitts parallel zueinander verlaufend angeordnet. Da die Strahlqualität in der schmalen Richtung beugungsbegrenzt ist und in der Junction-Ebene ca. 1.000-fach beugungsbegrenzt ist, kann die von einem Laserdiodenarray emittierte Strahlung nicht mit zylindrischen Linsen und sphärischen Linsen oder einer Kombination hieraus in einen kleinen und kreisförmigen Fleck fokussiert werden, was die Anwendung z.B. zur Einkopplung in einer optischen Faser oder das sogenannte "End-on-Pumpen" von Festkörperlasern, in Verbindung mit einem Laserdiodenarry einschränkt.

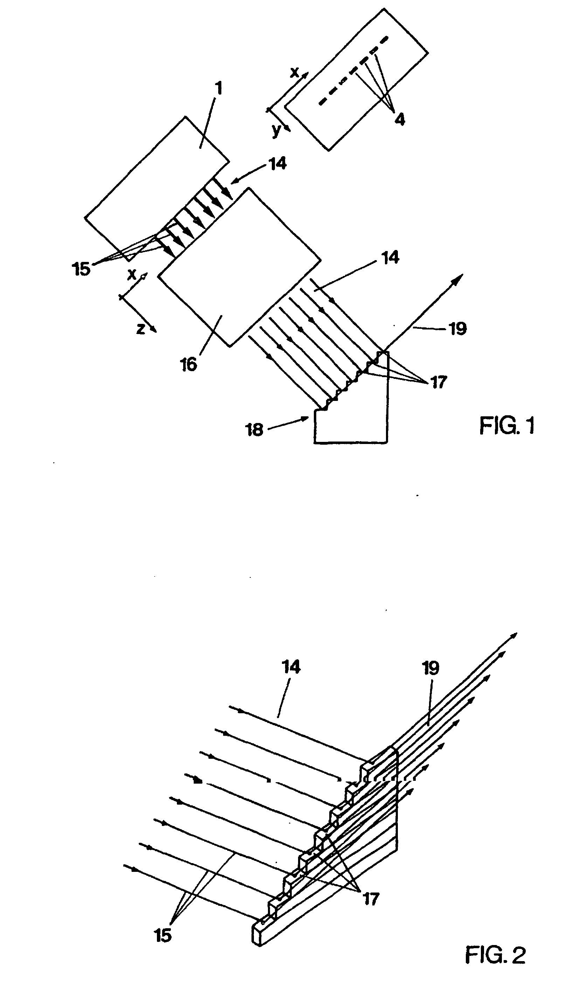

Die oben erwähnte US-PS 4,986,634 beschreibt eine Anordnung, bei der mehrere Halbleiterlaser in einer Reihe angeordnet sind. Die einzelnen Laserstrahlen fallen auf jeweilige diesen Strahlen zugeordnete Spiegel, die zueinander versetzt sind, auf, und werden von dort, wie der Figur 1 dieser Druckschfift zu entnehmen ist, reflektiert. Aus dem Ausgangsmuster wird nach der ersten Reflexion ein Muster erhalten, bei dem die einzelnen Strahlungsanteile näher zueinanderrücken und dabei der Füllfaktor erhöht wird. Die weitere Umlenkung der Strahlen, die von diesen Spiegeln reflektiert sind, erfolgt durch einen Strahlteiler, der dazu dient, die Strahlen mit den Strahlen eines weiteren linearen Laserfelds zu vereinigen. Es bleiben also mit dieser Anordnung nach der ersten Reflexion die Strahlanteile der einzelnen Halbleiterlaserquellen und damit auch diejenigen von Laserdioden in der Slow-Richtung gesehen nebeneinander angeordnet, wodurch der Füllfaktor erhöht wird; damit ist es nicht möglich, die Strahlqualität in beiden Richtungen, d.h. in der Slow- und der Fast-Richtung, auszugleichen.

Aus der WO-A-95/15510 ist eine Strahlformugsvorrichtung für eine Laseranordnung bekannt, wobei die Laseranordnung einen Strahl mit einem Strahlqualitätsfaktor Mₓ² in einer Richtung und einen Strahlqualitätsfaktor M_{y} ² in einer orthogonalen Richtung besitzt. Die Strahlformungsvorrichtung besitzt eine Vielzahl von im wesentlichen parallelen Reflexionsflächen, die eine Vielzahl von unterschiedlichen Propagationspfaden durch die Strahlformungsvorrichtung definieren. Jeder Pfad setzt eine jeweilige, unterschiedliche Anzahl Reflexionen zwischen den Reflexionsflächen ein, so daß unter der Benutzung Bereiche eines Eingangsstrahls von der Laservorrichtung in die Strahlformungsvorrichtung jeweiligen unterschiedlichen Propagationspfaden folgen und so rekonfiguriert werden, um einen Ausgangsstrahl zu bilden, in dem einer der Strahlqualitätsfaktoren Mₓ² und M_{y}² verringert wird. Für diese WO-A-95/15510 wurde das Europäische Verfahren eingeleitet; der Inhalt dieses Dokuments ist daher Stand der Technik gemäß Artikel 54(3) und (4) EPÜ.

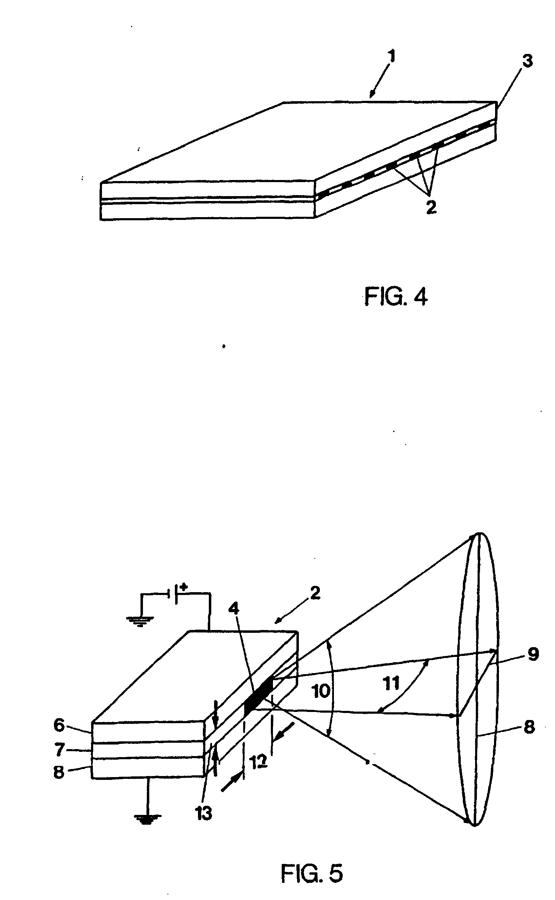

Die EP-B1 0 484 276 beschreibt eine Anordnung zur Formung und Führung von Strahlen mehrerer Strahlungsquellen, bei der die Strahlen einzelner Diodenlaser (siehe Figur 1) jeweils über Funktionselemente auf ein optisches Bauteil abgebildet werden. Ein optisches Bauteil, wie es jedem Strahl zugeordnet ist, ist in der Figur 4b dargestellt. Bei diesem optischen Bauteil handelt es sich um ein Abbé-König-Prisma, das den jeweiligen Strahl an drei Prismenflächen reflektiert. Die einzelnen Strahlquerschnitte sind jeweils nach der ersten Reflexion gespiegelt und um einen Winkel um die jeweiligen Strahlachsen gedreht. Nach der zweiten Reflexion an der nächsten Prismenfläche wird dann der jeweilige Strahlquerschnitt wiederum gespiegelt und um einen weiteren Winkel um seine Strahlachse gedreht und nach der dritten Reflexion sind die jeweiligen Strahlquerschnitte wiederum gespiegelt und um einen weiteren Winkel um die Strahlachse gedreht, so daß sich nach der dritten Reflexion eine gespiegelte und um 90° gedrehte Anordnung der einzelnen Strahlquerschnitte ergibt.

Aus der US-A-5,168,401 ist ein optisches System bekannt, das in Verbindung mit einem zweidimensionalen Feld einzelner Lichtquellen eingesetzt werden soll. Die Hauptkomponente dieses optischen Systems ist eine Prismen-Linsen-Struktur, wie sie in Figur 13 dargestellt ist. Einzelne Strahlen einzelner Strahlenquellen werden auf Reflexionsflächen M1 über Mikrolinsen eingestrahlt. Von den ersten Reflexionsflächen M1 werden sie auf die zweiten Reflexionsflächen M2 geführt und abgestrahlt. Nach den ersten Reflexionsflächen ergeben sich Strahlquerschnitte, die in der z-Richtung gesehen hintereinander liegen. In der zx-Ebene betrachtet ergeben sich einzelne Streifen. Nach der zweiten Reflexion wird ein Strahlungsfeld erhalten, bei dem die einzelnen Strahlquerschnitte, betrachtet in der xy-Ebene, gedreht sind. Die einzelnen Refelxionsflächen M1 sind durch die Flächen, die mit einer Länge mal Breite A x A₁ bezeichnet sind, als auch durch die zweiten Reflexionsflächen M2 voneinander beabstandet. Hieraus ergibt sich das Erfordernis, daß die einzelnen Strahlquerschnitte der Strahlung eines Strahlungsfelds ausreichend voneinander beabstandet sein müssen, da sie jeweils nur über die Linsenflächen und die zugeordneten Flächen A x A₁ auf die ersten Reflexionsflächen M1 eingestrahlt werden können. Dies bedeutet für ein zusammenhängendes Strahlungsfeld, beispielsweise von einer dicht gepackten linearen Anordnung einzelner Diodenlaser abgestrahlt, daß ein gewisser Strahlungsanteil zwischen den benachbarten Flächen A x A₁ im Bereich der Spiegelflächen M2 (an deren Rückseiten) verlorengeht. Weiterhin bringt diese Anordnung Probleme dahingehend mit sich, daß ein Ausgleich der Strahlqualität in beiden Richtungen nur bei bestimmten Diodenlaserbarren-Konfigurationen möglich ist.

Ausgehend von der vorstehend angesprochenen Problematik liegt der vorliegenden Erfindung die Aufgabe zugrunde, eine Anordnung anzugeben, die für auf einer Linie liegende und in einer gemeinsamen Ebene angeordnete Laserdioden einsetzbar ist und mit der die Strahlen der einzelnen Laserdioden zu einem im wesentlichen gleichmäßigen Strahlenfeld oder einem Strahlenfeldmuster abbildbar sind.

Diese Aufgabe wird bei einer Anordnung zur Formung und Führung von Strahlen eines geradlinigen Laserdlodenarrays mit den eingangs genannten Merkmalen dadurch gelöst, daß der Einstrahlwinkel der Strahlen (14) und die Stufenhöhe des treppenartigen Spiegels (18) so eingestellt sind, daß in der x'y'-Ebene, die senkrecht zu der Ausbreitungsrichtung der reflektierten Strahlen steht, ein in y'-Richtung stufenförmig zueinander versetztes Strahlmuster (20) gebildet ist.

Mit den einfachen in den figuren 1-3 dargestellten Reflexionsflächen können die Strahlquerschnitte eines solchen Laserdiodenarrays, durch eine entsprechende Neigung der Reflexionsflächen zu dem einfallenden Strahl, so angenähert werden, daß die einzelnen Strahlungsfelder, die von den Austrittsfenstern der Laserdioden ausgehen, dicht nebeneinander gelegt sind. In einer Ausbildung der Anordnung gemäß der Erfindung besitzen die einzelnen Refelexionsflächen jeweils einen unterschiedlichen Abstand zu den ihnen zugeordneten Strahl-Austrittsflächen der Laserdioden des Arrays, wobei der sich ändernde Abstand sequentiell der Reihenfolge der Laserdioden des Arrays entspricht. Entsprechend der Wahl des Abstandes der einzelnen Strahlaustrittsflächen der Laserdioden des Arrays zueinander wird vorzugsweise auch der Abstand der Reflexionsflächen sowie der Versatz der Reflexionsflächen zueinander ausgewählt und den Erfordernissen angepaßt. Vorzugsweise liegen jedoch die Zentren der bestrahlten Flächenbereiche der einzelnen Reflexionsflächen, auf die die jeweiligen Strahlen der einzelnen Laserdioden auftreffen, auf einer Geraden, d.h. diese Reflexionsflächen besitzen einen gleichen Versatz zueinander sowie einen sich um jeweils denselben Betrag ändernden Abstand zu den Strahlaustrittsflächen der Laserdioden in Bezug auf die aufeinanderfolgenden, in einer Reihe angeordneten Laserdioden eines Arrays.

Um mit einer solchen einfachen optischen Anordnung die Strahlen zu einem geschlossenen Strahlungsfeld zusammenzuführen, hat es sich als vorteilhaft erwiesen, der ersten Reflexionsflächen im Strahlengang jeder von einer Laserdiode ausgehenden Strahlung mindestens eine zweite, weitere Reflexionsfläche zuzuordnen. Diese zweiten Reflexionsflächen werden wiederum in Ebenen angeordnet, die einen Versatz zueinander und einen unterschiedlichen Abstand zu den ihnen zugeordneten ersten Reflexionsflächen aufweisen, wobei der Versatz und der sich ändernde Abstand der Reflexionsflächen wiederum sequentiell der Reihenfolge der ersten Reflexionsflächen entspricht. Je nach Anforderung an das zu bestrahlende Feld in der Abbildungsebene des Lasediodenarrays können jeder zweiten Reflexionsfläche weitere Reflexionsflächen in Strahlrichtung folgen, wobei vorzuqsweise die maximale Anzahl der aufeinanderfolgenden Reflexionsflächen, die ein Strahl durchläuft, vier beträgt.

Für ein einfaches, optisches Element, durch das die einzelnen Reflexionsflächen gebildet und geformt werden können, hat sich ein treppenartig aufgebauter Spiegel als vorteilhaft erwiesen. Ein solcher treppenartig aufgebauter Spiegel kann durch einen entsprechend mit einer Spiegelfläche beschichteten Substratträger, beispielsweise durch Aufdampfen, bereitgestellt werden. Es ist allerdings auch möglich, einen solchen Treppenstufenspiegel auf einem Glassubstrat mittels Diamantwerkzeugen einzuschleifen, wobei ein solcher Treppenstufen-Spiegel den Vorteil hat, daß er äußerst stabil und verzugsfrei ist. Die erfindungsgemäße Anordnung hat den Vorteil, daß die jeweiligen ersten, zweiten sowie weiteren Reflexionsflächen durch ebene Spiegelelemente gebildet werden können, die also sehr einfach herstellbar sind. Aufgrund dieses einfachen Aufbaus können dann auch Strahlen, die von Laserdiodenarrays mit mehreren Reihen Laserdioden ausgehen, in einer Abbildungsebene als zusammenhängendes Strahlungsfeld abgebildet werden, wobei jeder geradlinigen Reihe Laserdioden des Arrays eine oder mehrere Reflexionsanordnungen im Strahlengang zugeordnet werden, wie sie vorstehend beschrieben sind.

Eine weitere, bevorzugte Ausführung, um den jeweiligen von einer Laserdiode der Anordnung ausgehenden Strahl unter Berücksichtigung des vorstehend angegsbenen Prinzips in einer Ebene so abzubilden, daß beispielsweise ein geschlossenes Strahlungsfeld erzeugt wird, ist dadurch gegaben, daß dem Strahl jeder Laserdiode ein stab- oder bandartiger Wellenleiter mit einem sich in Strahlrichtung öffnenden Keilwinkel zugeordnet ist, in dessen eine Stirnfläche der Strahl eintritt und an dessen gegenüberliegender Stirnfläche jeweils die dem Strahl zugeordnete erste Reflexionsfläche derart gebildet ist, daß der Strahl seitwärts austritt. Vorzugsweise besitzt der Wellenleiter zwei ebene Begrenzungsflächen, die von der Strahleintrittsseite zu der Strahlaustrittsseite unter einem Winkel zueinander verlaufen und auf einer gemeinsamen Ebene senkrecht stehen; der Winkel liegt hierbei im Bereich von 5° bis 15° und die Länqe dieses Wellenleiters liegt im Bereich von 2 bis 10 mm. Durch einen solchen streifen- oder bandartigen Wellenleiter kann die von jeder Laserdiode ausgehende Strahlung definiert zu der ersten Reflexionsfläche geführt und auf dem Weg dorthin komprimiert werden. Ein solcher Wellenleiter ist so zu dem Strahl bzw. dem Austrittsfenster der Laserdiode angeordnet, daß die beiden unter einem Winkel verlaufenden Flächen des Wellenleiters senkrecht zu der großen Achse des elliptischen Strahlquerschnitts stehen. Weiterhin hat ein solcher Keilwinkel-Wellenleiter den Vorteil, daß keine abbildende Optik benötigt wird und die Möglichkeit besteht, den (die) Wellenleiter und die Laserdioden auf einem gemeinsamen Substrat, bevorzugt Silizium, integriert aufzubauen.

Die Austrittsfläche jedes Wellenleiters kann derart zu der Ausbreitungsrichtung des Strahls in dem Wellenleiter abgeschrägt und verspiegelt werden, d.h. als Reflexionsfläche ausgebildet werden, daß der jeweilige Strahl unter einem definierten Winkel austritt und unter definiertem Versatz zu den Eingangsstrahlen in einer Abbildungsebene abgebildet wird. In dieser nach den Austrittsenden der Wellenleiter liegenden Abbildungsebene können wiederum jedem Strahl weitere Reflexionsflächen folgen, *d.h.* vorzugsweise eine weitere, zweite Reflexionsfläche, um die Strahlung in einer bestimmten Richtung zu führen bzw. zusammenzuführen so daß aus den einzelnen Strahlquerschnitten ein geschlossenes Strahlungsfeld erzeugt wird.

Weitere Einzelheiten und Merkmale der vorliegenden Erfindung ergeben sich aus der nachfolgenden Deschreibung eines Ausführungsbeispiels anhand der Zeichnungen. In der Zeichnung zeigt
- Figur 1: eine erste Ausführungsform einer Anordnung zur Formung und Führung von Strahlen eines geradlinigen Laserdiodenarrays mittels eines Treppenspiegels in einer schematischen Darstellung, die fur Erläuterung dient,
- Figur 2: den Treppenspiegel der Figur 1 in einer schematisehen, perspektivischen Darstellung mit dem Verlauf der einfallenden Strahlung,
- Figur 3: den Strahlverlauf der Anordnung nach Figur 1 und Figur 2 in einer zu der Darstellung der Figur 1 gedrehten Ebene,
- Figur 4: ein Laserdiodenarray mit mehreren Laserdioden,
- Figur 5: schematisch eine Laserdiode des Arrays der Figur 4 mit dem aus der Strahlaustrittsfläche austretenden, typischen Strahlkegel,
- Figur 6: und 7 eine schematische Darstellung einer Ausführungsform der Erfindung unter Verwendung von zwei Treppenspiegeln,
- Figur 8: eine Ausführungsform ähnlich der Ausführungsform der Figuren 1 bis 3 mit einer speziellen Abbildungsoptik, die zur Erläuterung dient,
- Figur 9: einen Schnitt entlang der Schnittlinie IX-IX in Figur 8, und
- Figur 10: einen Schnitt entlang der Schnittlinie X-X in Figur 8.

Die Erfindung befaßt sich mit der Formung und Führung von Strahlen eines geradlinigen Laserdiodenarrays 1, bei dem eine Mehrzahl emittierender Laserdioden 2, in dem Beispiel der Figur 4 insgesamt acht solcher Laserdioden 2, auf einer geraden Linie und in einer gemeinsamen Ebene 3 mit den Strahlaustrittsflächen 4 liegen. Eine typische Struktur einer Laserdiode 2 ist in Figur 5 dargestellt. Die Anordnung besitzt eine stark dotierte p⁺-Phase, eine p-Phase 6 und eine n-Phase 7. Die Strahlaustrittsfläche 4 einer emittierenden Zone des aktiven Mediums besitzt eine gewisse Ausdehnung in Richtung der Ebene des Übergangs der p-Phase und der n-Phase 7, während sie relativ schmal senkrecht zu diesen Ebenen verläuft. Aufgrund der Geometrie des aktiven Mediums tritt aus der Strahlaustrittsfläche 4 der in Figur 5 angedeuteten typische Strahlenkegel aus, der einen elliptischen Querschnitt besitzt, wobei die große Achse 8 senkrecht zu der Ebene des pn-Übergangs verläuft, während die kleine Achse 9 des elliptischen Querschnitts parallel zu der Ebene des pn-Übergangs verläuft. Typischerweise ist die große Ausdehnung des Strablkegels senkrecht zu der Ebene des pn-Übergangs, die auch als "Fast-Richtung" bezeichnet wird, mit einem Divergenzwinkel 10 von etwa 90° behaftet, während der Strahlkegel in Richtung der kleinen Achse 9 bzw. senkrecht zu der Fast-Richtung, die auch als "Slow-Richtung" bezeichnet wird, einen Divergenzwinkel 11 von ca. 10° besitzt. Eine typische Abmessung des aktiven Mediums bzw. der entsprechenden Strahlaustrittsflärhe 4 beträgt 100 µm in der Längsrichtung 12, d.h. in der Richtung der kleinen Achse 9 des Strahlquerschnitts, während die Abmessung in der Querrichtung 13, d.h. in Richtung der großen Achse 8 des Strahlquerschnitts, etwa 1 µm beträgt. In typischen Laserdiodenanordnungen werden bis zu 24 Laserdioden auf einem Array 1, wie es die Figur 4 zeigt, mit einer Länge von einem Zentimeter integriert.

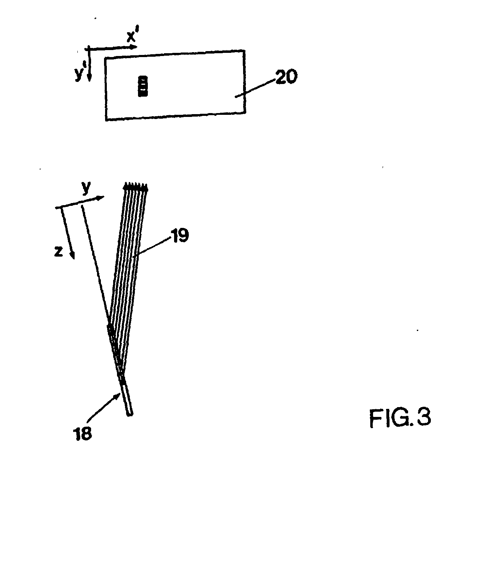

In einer ersten Ausführungs form einer Anordnung, die zur Erläuterung dient, und in den Figuren 1 bis 3 dargestellt ist, wird die von einem Laserdiodenarray 1 ausgehende Strahlung 14, d.h. die einzelnen Strahlkegel 15 der einzelnen Laserdioden 2, über eine Abbildungsoptik 16, die in Figur 1 nur schematisch dargestellt ist, auf einzelne, erste Reflexionsflächen 17 eines Treppenstufenspiegels 18 abgebildet. An den einzelnen ersten Reflexionsflächen 17 des Treppenstufenspiegels 18 werden die einzelnen Strahlen 15 reflektiert und die reflektierten Strahlen zu einer Abbildungsebene 20 hin abgebildet. Es ist vorteilhaft, daß der Einstrahlwinkel in der xz-Ebene auf die ersten Reflexionsflächen 17 und die Stufenhöhe, d.h. der seitliche Versatz der einzelnen Reflexionsflächen 17, sowie gegebenenfalls der Abstand der Reflexionsflächen 17 von den Strahlaustrittsflächen 4, die in Figur 1 in der xy-Ebene liegend angedeutet sind, so abgestimmt werden, daß sich in der xz-Ebene die Strahlung aller Laserdioden 2 des Laserdiodenarrays 1 in einem Strahl vereinen. In der dazu senkrechten Ebene (yz-Ebene) werden der Einstrahlwinkel und die Orientierung des Treppenspiegels 18 so abgestimmt, daß die von in etwa waagrechten Spiegelsegmenten reflektierten Strahlen 19 nicht von den folgenden, senkrechten Segmenten des Treppenstufenspiegeis 18 weg reflektiert werden. Dies führt gleichzeitig zum relativen Versatz der Teilstrahlen in der yz-Ebene, so daß die Teilstrahlen den einzelnen Laserdioden 2 in der schmalen Richtung (y-Richtung) nebeneinander angeordnet werden. Die Strahlqualität entlang der y-Achse ist um einen Faktor der Laserdiodenzahl verringert und gleichzeitig erhöht sich die Strahlqualität in der Junction-Ebene (x-Richtung) um den gleichen Faktor. Dadurch werden die Strahlqualitäten in beiden Richtungen vergleichbar und die Gesamtstrahlung des Laserdiodenarrays 1 kann in einem kreisförmigen Fleck fokussiert werden. Figur 3 zeigt eine Ansicht der yz-Ebene sowie die Ausgangsstrahlmuster in der Ausgangsebene 20. Diese Ausgangsstrahlen können mit der nachgeschalteten Optik in einen quasi kreisförmigen Fleck abgebildet werden.

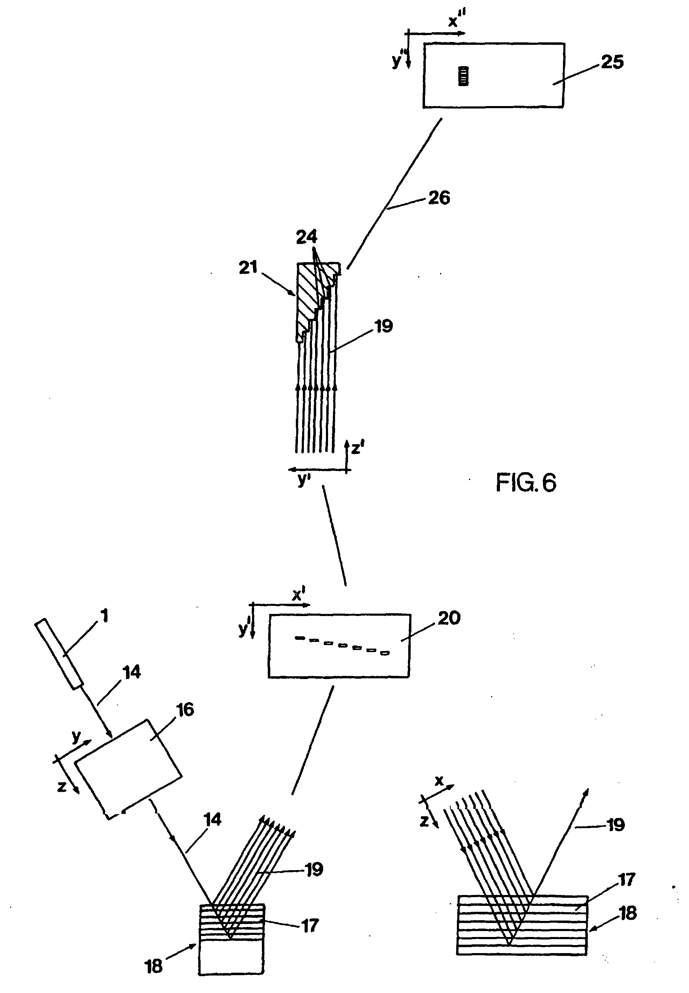

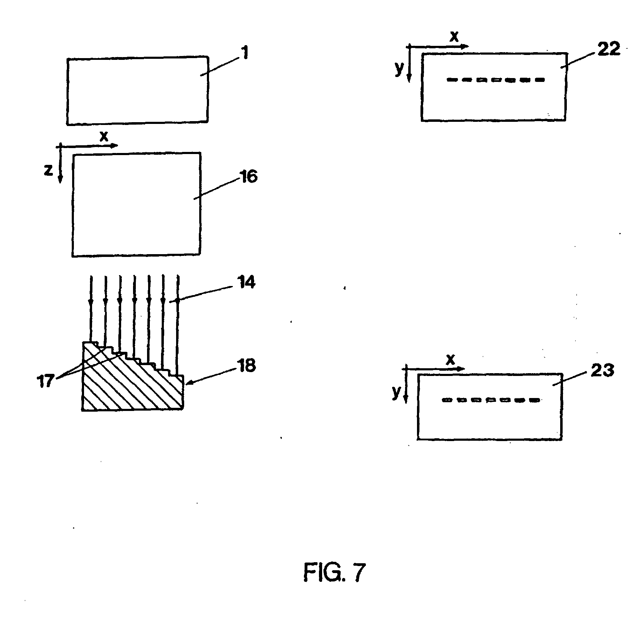

Während in der ersten Ausführungsform, wie sie in den Figuren 1 bis 3 gezeigt ist, die Strahlung über einen einzelnen Treppenstufenspiegel 18 zu einem geschlossenen Strahlungsfeld in der Abbildungsebene zusammengeführt wird, stellen die Figuren 6 und 7 eine Ausführungsform gemäß der Erfindung dar, nach der neben einem ersten Treppenstufenspiegel 18 im Strahlengang ein zweiter Treppenstufenspiegel 21 eingesetzt wird.

An dieser Stelle ist anzumerken, daß in den einzelnen Figuren hinsichtlich der verschiedenen Ausführungsformen identische oder vergleichbare Bauteile mit denselben Bezugszeichen bezeichnet sind.

Wie die Darstellung der Figur 6 zeigt, wird die Strahlung 14 der Laserdioden des Laserdiodenarrays 1 wiederum über eine Abbildungsoptik 16 auf die ersten Reflexionsflächen 17, die durch einen ersten Treppenstufenspiegel 18 gebildet werden, abgebildet. Die reflektierte Strahlung 19 zeigt nach dem Treppenstufenspiegel 18 in einer in der x'y'-Ebene aufgespannten Abbildungsebene 20 ein stufenförmig zueinander versetztes, äquidistant beabstandetes Strahlmuster, wie dies schematisch gezeigt ist. Zum Vergleich ist in Figur 7 das Strahlungsmuster in der rechten, oberen Abbildungsebene hinter den Strahlaustrittsflächen der Laserdioden des Laserdiodenarrays 1 dargestellt, während in der unteren Abbildungsebene 23 das Strahlmuster der Strahlung 14 gezeigt ist, bevor die Strahlung 14 auf die einzelnen Reflexionsflächen 17 des Treppenstufenspiegels 18 fällt. Wie die beiden Abbildungsebenen 22 und 23 zeigen, verlaufen die bestrahlten Felder in der Abbildungsebene 23 auf einer geraden Linie mit einem äquidistanten Abstand zueinander. Nach dem Treppenstufenspiegel 18 wird die reflektierte Strahlung 19 auf den zweiten Treppenstufenspiegel 21 geführt. Der Einstrahlwinkel und die Stufenhöhe des ersten treppenstufenspiegels 18 sind so eingestellt, daß der durch die Reflexion erzeugte Versatz etwas größer als die Dimension eines einzelnen Diodenstrahls in der Abbildungsebene der vorgeschalteten Abbildungsoptik in der y-Richtung (Fast-Richtung) ist. Der zweite Treppenstufenspiegel 21, an dem die Strahlung 19 bzw. die einzelnen Strahlen an zweiten Reflexionsflächen 24 reflektiert werden, ist hinsichtlich des Einstrahlwinkels und der Stufenhöhe so eingestellt, daß in einer hinter dem zweiten Treppenstufenspiegel 21 liegenden Abbildungsebene (x"y"-Ebene) 25 alle Teilstrahlen in der y"-Richtung nebeneinander angeordnet sind und dort ein gleichförmiges, geschlossenes Strahlungsfeld bilden.

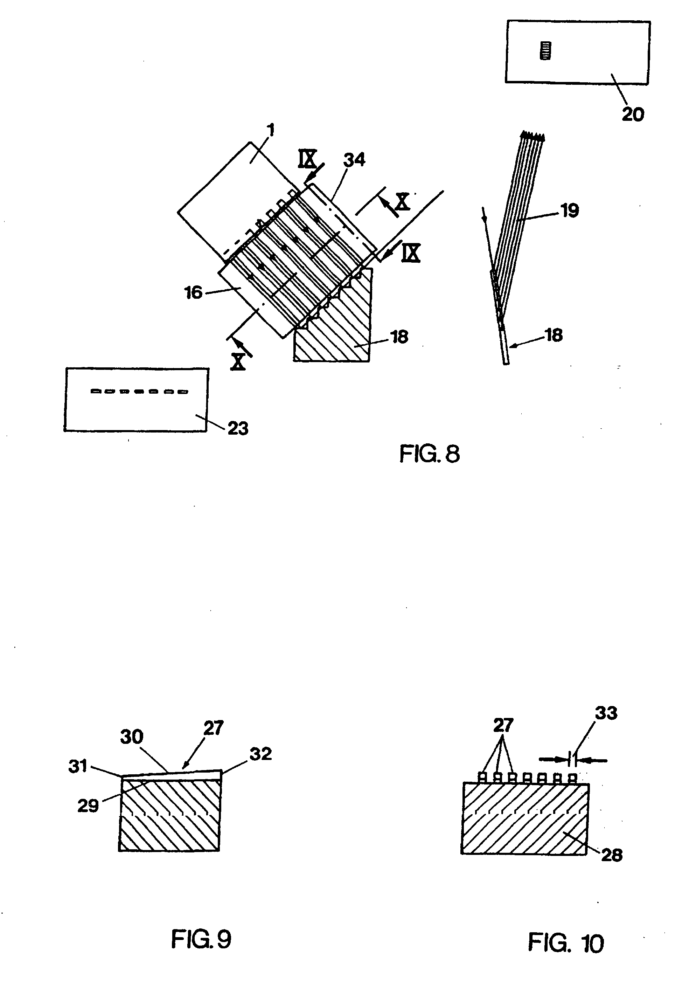

In den Figuren 8 bis 10 ist eine der Figur 1 entsprechende Abbildung dargestellt, wobei die Abbildungsoptik 16 der Figur 1 zwischen dem Laserdiodenarray 1 und dem ersten Treppenstufenspiegel 18 als Alternative zu konventionellen Mikro- und Makrooptiken, wie zylindrische und sphärische Linsen, in der Form von streifenartigen Wellenleitern 27 auf einem Trägerkörper 28 aufgebracht gebildet ist. Jeder Wellenleiter 27 besitzt einen Keilwinkel in der Fast-Richtung des Strahls der ihm zugeordneten Laserdiode, wobei der Keilwinkel, d.h. der Winkel zwischen der Basisfläche 29, mit der der Wellenleiter 27 mit dem Trägerkörper 29 verbunden ist, und der Außenfläche 30, etwa 10° beträgt. Die Diodenstrahlung wird in einen solchen Wellenleiter 27 von der schmalen Stirnfläche 31 aus eingekoppelt und tritt aus der gegenüberliegenden, großen Stirnfläche 32 aus. Der Keilwinkel dient zur Reduzierung der Divergenz in der Fast-Richtung. Jeder Wellenleiter 27 besitzt mindestens die Breite 33 (Figur 10) entsprechend einer einzelnen Laserdiode bzw. deren Strahlaustrittsfläche 4. An der schmalen Stirnfläche 31 beträgt die Höhe der Stirnfläche 31 einige µm bis einige 10 µm, während an der großen Stirnfläche 32 die Höhe 10 µm bis etwa 100 µm beträgt. Diese streifenartigen Wellenleiter 27 können zum Beispiel durch Beschichtungsverfahren auf dem Trägerkörper 28 aufgebracht werden. Sie können allerdings auch durch auf den Träger aufgekittete Glaskeilplättchen gebildet werden. Eine Alternative zu einzelnen, streifenartigen Wellenleitern 27 ist dadurch gegeben daß die einzelnen Wellenleiter 27, wie sie in den Figuren 8 bis 10 dargestellt sind, in einem gemeinsamen Bandwellenleiter mit entsprechenden Keilwinkel zusammengefaßt werden, wie dies durch den Rahmen 34 in Figur 8 angedeutet ist. Die Abbildungsebene 23 zeigt wiederum die Strahlungsfelder auf der Austrittsseite der Wellenleiter 27, bevor sie auf den Treppenstufenspiegel 18 fallen, während die Abbildungsebene 20 der Abbildungsebene 20 der Figur 3 entspricht.

## Patentansprüche

1. Anordnung zur Formung und Führung von Strahlen eines geradlinigen Laserdiodenarrays (1) mit in einer gemeinsamen Ebene liegenden Strahlaustrittsflächen (4) mittels einer Reflexionsoptik, wobei die Ebene parallel zu der xy-Ebene liegt und die x-Achse parallel zu dem pn-Übergang der Laserdioden (2) des Arrays (1) liegt und wobei die Abstrahlrichtung der Laserdioden parallel zu der z-Achse liegt, wobei x, y und z ein rechtwinkliges Koordinatensystem bilden, wobei jedem Austrittsstrahl (15) mindestens ein erstes Reflexionselement mit einer Reflexionsfläche zugeordnet ist und die Reflexionsflächen (17) in Ebenen angeordnet sind, die einen Versatz zueinander aufweisen, der sequentiell der Reihenfolge der Laserdioden des Arrays entspricht, wobei die Reflexionsflächen jeweils einen unterschiedlichen Abstand zu den ihnen zugeordneten Strahlaustrittsflächen aufweisen, und wobei die Reflexionsflächen durch einen treppenartigen Spiegel (18) gebildet sind, **dadurch gekennzeichnet, daß** der Einstrahlwinkel der Strahlen (14) und die Stufenhöhe des treppenartigen Spiegels (18) so eingestellt sind, daß in der x'y'-Ebene, die senkrecht zu der Ausbreitungsrichtung der reflektierten Strahlen (19) steht, ein in y'-Richtung stufenförmig zueinander versetztes Strahlmuster (20) gebildet ist.

2. Anordnung nach Anspruch 1, **dadurch gekennzeichnet, daß** der sich ändernde Abstand der Reflexionsflächen (17) sequentiell der Reihenfolge der Laserdioden (2) des Arrays (1) entspricht.

3. Anordnung nach Anspruch 1 oder 2, **dadurch gekennzeichnet, daß** die Zentren der bestrahlten Flächenbereiche der einzelnen, ersten Reflexionsflächen (17) auf einer Geraden liegen.

4. Anordnung nach einem der Ansprüche 1 bis 3, **dadurch gekennzeichnet, daß** der jeweilige Versatz und die jeweilige Abstandsänderung benachbarter, erster Reflexionsflächen (17) von gleicher Größe sind.

5. Anordnung nach einem der Ansprüche 1 bis 4, **dadurch gekennzeichnet, daß** jeder ersten Reflexionsfläche (17) mindestens eine weitere, zweite Reflexionsfläche(24) zugeordnet ist und diese zweiten Reflexionsflächen (24) in Ebenen angeordnet sind, die einen Versatz zueinander und einen unterschiedlichen Abstand zu den ihnen zugeordneten ersten Reflexionsflächen (17) aufweisen, wobei der Versatz und der sich ändernde Abstand der zweiten Reflexionsflächen (24) sequentiell der Reihenfolge der ersten Reflexionsflächen (17) entspricht, wobei der Einstrahlwinkel der Strahlen auf die zweiten Reflexionsflächen (24) und deren Stufenhöhe so eingestellt sind, daß durch die Reflexion ein Versatz im wesentlichen senkrecht zu dem Versatz des ersten Strahlmusters gebildet ist.

6. Anordnung nach Anspruch 5, **dadurch gekennzeichnet, daß** jeder zweiten Reflexionsfläche (24) dritte bis n-te Reflexionsflächen zugeordnet sind und die n-ten Reflexionsflächen in Ebenen angeordnet sind, die einen Versatz zueinander und einen unterschiedlichen Abstand zu den ihnen zugeordneten (n-1)-ten Reflexionsflächen, aufweisen, wobei der Versatz und der sich ändernde Abstand der Reflexionsflächen sequentiell der Reihenfolge der (n-1)-ten Reflexionsflächen entspricht.

7. Anordnung nach Anspruch 6, **dadurch gekennzeichnet, daß** n = 3 oder 4 ist.

8. Anordnung nach Anspruch 5, **dadurch gekennzeichnet, daß** die zweiten Reflexionsflächen (24) durch einen treppenartig aufgebauten zweiten Spiegel (21) gebildet sind.

9. Anordnung nach einem der Ansprüche 1 bis 6, **dadurch gekennzeichnet, daß** dem Strahl jeder Laserdiode (2) ein streifen- oder bandartiger Wellenleiter mit einem in Strahlrichtung sich öffnenden Keilwinkel zugeordnet ist, in dessen eine Stirnfläche der Strahl eintritt und an dessen gegenüberliegender Stirnfläche jeweils die dem Strahl zugeordnete erste Reflexionsfläche als abgeschrägte, den Strahl seitwärts reflektierende Fläche ausgebildet ist.

10. Anordnung nach Anspruch 9, **dadurch gekennzeichnet, daß** der Wellenleiter zwei ebene Begrenzungsflächen aufweist, die von der Strahleintrittsseite zu der Strahlaustrittsseite unter einem Winkel zueinander verlaufen und auf einer gemeinsamen Ebene senkrecht stehen.

11. Anordnung nach Anspruch 10, **dadurch gekennzeichnet, daß** der Winkel im Bereich von 5° und 15° liegt und die Länge des Wellenleiters im Bereich von 2 mm bis 10 mm liegt.

12. Anordnung nach Anspruch 1, **dadurch gekennzeichnet, daß** zwischen Strahlaustrittsfläche und dem ersten Reflexionselement eine Abbildungsoptik (16) angeordnet ist.

13. Anordnung nach Anspruch 12, **dadurch gekennzeichnet, daß** die Abbildungsoptik (16) durch einen streifen- oder bandartigen Wellenleiter (27) mit einem in Strahlrichtung sich öffnenden Keilwinkel gebildet ist, in dessen eine Stirnfläche (31) der Strahl ointritt und der aus dessen gegenüberliegender, der ersten Reflexionsfläche benachbarten Stirnfläche (32) jeweils austritt.

14. Anordnung nach Anspruch 5, **dadurch gekennzeichnet, daß** die ersten und zweiten Reflexionsflächen (17; 24) derart ausgerichtet sind, daß die einzelnen Strahlen (19) der Dioden nach der ersten Reflexionsfläche (17) in einer Abbildungsebene (20) treppenstufenartig zueinander versetzt sind und nach der zweiten Reflexionsfläche (24) in einer Abbildungsebene (25) übereinander bzw. untereinander liegen derart, daß sie ein zusammenhängendes Strahlungsfeld bilden.

15. Anordnung nach einem der Ansprüche 9 bis 11 und 13, **dadurch gekennzeichnet, daß** der/die Wellenleiter und die Laserdioden (2) des Arrays (1) auf einem gemeinsamen Substrat angeordnet sind.

16. Anordnung nach Anspruch 15, **dadurch gekennzeichnet, daß** das Substrat aus Silizium gebildet ist.

## Revendications

1. Configuration pour la formation et le guidage de rayons d'un système de diodes à laser (1) rectiligne avec des surfaces de sortie de rayons (4) agencées dans un plan commun à l'aide d'un système optique de réflexion, étant donné que le plan est parallèle au plan xy et l'axe x est parallèle à la transition pn des diodes à laser (2) du système (1), et étant donné que le sens de rayonnement des diodes à laser est parallèle à l'axe z, étant donné que x, y et z constituent un système de coordonnées rectangulaires, étant donné qu'à chaque rayon de sortie (15) est affecté au moins un premier élément réfléchissant avec une surface réfléchissante et que les surfaces réfléchissantes (17) sont agencées dans des plans présentant un décalage l'un par rapport à l'autre correspondant séquentiellement à l'ordre de disposition des diodes à laser du système, étant donné que les surfaces réfléchissantes sont chacune situées à une distance différente des surfaces de sortie de rayons qui leur sont affectées et, que les surfaces réfléchissantes sont constituées par un miroir (18) en forme d'escalier, **caractérisée par le fait que** l'angle d'incidence des rayons (14) et la hauteur de marche du miroir en forme d'escalier (18) sont ajustés de manière à ce que, dans le plan x'y' perpendiculaire au sens de propagation des rayons réfléchis (19), un modèle de rayonnement (20) décalé en échelons dans le sens y' soit constitué.

2. Configuration conformément à la revendication 1, **caractérisée par le fait que** l'écartement variable des surfaces réfléchissantes (17) correspond séquentiellement à l'ordre de disposition des diodes à laser (2) du système (1).

3. Configuration conformément à la revendication 1 ou 2, **caractérisée par le fait que** les centres des zones exposées au rayonnement des premières surfaces réfléchissantes (17) individuelles sont disposés en ligne droite.

4. Configuration conformément à l'une des revendications 1 à 3, **caractérisée par le fait que** le décalage individuel et la variation individuelle de l'écartement de premières surfaces réfléchissantes (17) adjacentes ont la même grandeur.

5. Configuration conformément à l'une des revendications 1 à 4, **caractérisée par le fait qu'**à chaque première surface réfléchissante (17) est au moins affectée une autre, une deuxième surface réfléchissante (24), et que ces deuxièmes surfaces réfléchissantes (24) sont agencées dans des plans présentant un décalage l'un par rapport à l'autre et un écartement variable avec les premières surfaces réfléchissantes (17) qui leurs sont individuellement affectées, étant donné que le décalage et la variation individuelle de l'écartement des deuxièmes surfaces réfléchissantes (24) correspondent séquentiellement à l'ordre de disposition des premières surfaces réfléchissantes (17), étant donné que l'angle d'incidence des rayons sur les deuxièmes surfaces réfléchissantes (24) et les hauteurs de marches correspondantes sont ajustés de manière à ce que la réflexion cause un décalage essentiellement perpendiculaire au décalage du première modèle de rayonnement.

6. Configuration conformément à la revendication 5, **caractérisée par le fait qu'**à chaque deuxième surface réfléchissante (24) sont affectées une 3^{ème} à une n-ième surface réfléchissante et que les n-ièmes surfaces réfléchissantes sont agencées dans des plans décalés l'un par rapport à l'autre et présentant un écartement variable avec les (n-1)-ièmes surfaces réfléchissantes qui leur sont affectées, étant donné que le décalage et la variation individuelle de l'écartement des surfaces réfléchissantes correspondent séquentiellement à l'ordre de disposition des (n-1)-ièmes surfaces réfléchissantes.

7. Configuration conformément à la revendication 6, **caractérisée par le fait que** n = 3 ou 4.

8. Configuration conformément à la revendication 5, **caractérisée par le fait que** les deuxièmes surfaces réfléchissantes (24) sont constituées par un deuxième miroir (21) en forme d'escalier.

9. Configuration conformément à l'une des revendications 1 à 6, **caractérisée par le fait qu'**au rayonnement de chaque diode à laser (2) est affecté un guide d'ondes en forme de bande avec un angle d'attaque s'ouvrant dans le sens du rayonnement ; le rayon pénètre dans l'une des faces terminales de ce dernier et, à sa face terminale opposée, la première surface réfléchissante affectée au rayon se présente comme surface inclinée réfléchissant le rayon de biais.

10. Configuration conformément à la revendication 9, **caractérisée par le fait que** le guide d'ondes comporte deux surfaces périphériques planes se déroulant du côté d'incidence du rayon vers le côté de sortie du rayon sous un angle l'un par rapport à l'autre et étant perpendiculaires sur un plan commun.

11. Configuration conformément à la revendication 10, **caractérisée par le fait que** l'angle est situé dans la plage de 5° à 15° et la longueur du guide d'ondes est située dans la plage de 2 mm à 10 mm.

12. Configuration conformément à la revendication 1, **caractérisée par le fait qu'**un système optique de représentation (16) est agencé entre la surface de sortie du rayon et le premier élément réfléchissant.

13. Configuration conformément à la revendication 12, **caractérisée par le fait que** le système optique de représentation (16) est constitué par un guide d'ondes (27) en forme de bande avec un angle d'attaque s'ouvrant dans le sens du rayonnement dans l'une des faces terminales (31) duquel le rayon pénètre et sort à sa face terminale opposée, la face terminale (32) adjacente à la première surface réfléchissante.

14. Configuration conformément à la revendication 5, **caractérisée par le fait que** les premières et deuxièmes surfaces réfléchissantes (17 ; 24) sont orientées de manière à ce que les différents rayons (19) des diodes soient, en aval de la première surface réfléchissante (17), décalées l'une par rapport à l'autre en forme d'escalier et, en aval de la deuxième surface réfléchissante (24), soient situés dans un plan de représentation (25) l'un au-dessus ou au-dessous de l'autre de manière à ce qu'ils constituent un champ de rayonnement cohérent.

15. Configuration conformément à l'une des revendications 9 à 11 et 13, **caractérisée par le fait que** le(s) guide(s) d'ondes et les diodes à laser (2) du système (1) sont agencés sur un substrat commun.

16. Configuration conformément à la revendication 15, **caractérisée par le fait que** le substrat est constitué de silicium.

## Claims

1. Arrangement for shaping and guiding the beams from a rectilinear laser diode array (1) with beam exit surfaces (4) laying on a common plane by reflecting optic, wherein said plane is lying parallel to the xy-plane and wherein the x-axis is lying parallel to the pn-junction of the laser diodes (2) of the array (1) and wherein the radiation direction of the laser diodes is lying parallel to the z-axis, wherein x, y and z forming a rectangular coordinate system, wherein at least one first reflecting element with a reflecting surface is assigned to each beam (15), and wherein the reflecting surfaces (17) are arranged on planes which are offset with respect to each other, the sequence of offsets corresponding to the sequence of the laser diodes of the array, the reflecting surfaces having each a different distance from the beam exit surfaces assigned to them, and wherein the reflecting surfaces are formed by a stair-like mirror (18), **characterized in that** the angle of incident of the beams (14) and the height of the steps of the stair-like mirror (18) is adjusted in a way that in the x'y'-plane, lying perpendicular to the propagation direction of the reflected beams (19), a step-like pattern (20) of beams to each other is formed in the y'-direction.

2. Arrangement according to claim 1, **characterized in that** the changing distance of the reflecting surfaces (17) corresponds to the sequence of the laser diodes (2) of the array (1).

3. Arrangement according to Claim 1 or Claim 2, **characterized in that** the centers of the irradiated surface areas of the individual first reflecting surfaces (17) are located on a straight line.

4. Arrangement according to one of Claims 1 to 3, **characterized in that** the respective offset and the respective change in the distance between adjacent first reflecting surfaces (17) is from the same extent.

5. Arrangement according to one of Claims 1 to 4, **characterized in that** at least one additional, second reflecting surface (24) is assigned to each first reflecting surface (17), and **in that** these second reflecting surfaces (24) are located on planes which are offset with respect to each other and having different distances from the first reflecting surfaces (17) assigned to them, wherein the offset and the change in the distance of the second reflecting surfaces (24) are corresponding to the sequence of the first reflecting surfaces (17), wherein the angle of incident of the beams on the second reflection surfaces (24) and the height of the steps is adjusted in a way, that an offset is formed in particular perpendicular to the offset of the beam pattern as a result of reflection.

6. Arrangement according to Claim 5, **characterized in that** third to n-th reflecting surfaces are assigned to each second reflecting surface (24), and **in that** the n-th reflecting surfaces are located on planes which are offset with respect to each other and are at different distances from the (n-1)-th reflecting surfaces assigned to them, wherein the offset and the change in the distance of reflecting surfaces are corresponding to the sequences of the (n-1)-th reflecting surfaces.

7. Arrangement according to Claim 6, **characterized in that** n = 3 or 4.

8. Arrangement according to Claims 5, **characterized in that** the second reflecting surfaces (24) are formed by a second mirror (21), configured in the form of a staircase.

9. Arrangement according to one of Claims 1 to 6, **characterized in that** a strip-like or ribbon-like waveguide with an opening wedge angle in the beam direction is assigned to the beam of each laser diode (2), the beam entering one end surface of the waveguide, and whereas the first reflecting surface assigned to the beam, configured as a beveled surface which reflects the beam sideways, is located at the other end.

10. Arrangement according to Claim 9, **characterized in that** the waveguide has two flat boundary surfaces, which form an angle with each other from the beam entry side to the beam exit side and which are perpendicular to a common plane.

11. Arrangement according to Claim 10, **characterized in that** the angle is in the range of 5° to 15°, and **in that** the length of the waveguide is in the range of 2 mm to 10 mm.

12. Arrangement according to Claim 1, **characterized in that** an optical imaging system (16) is provided between the beam exit surface and the first reflecting element.

13. Arrangement according to Claim 12, **characterized in that** the optical imaging system (16) is formed of a strip-like or ribbon-like waveguide (27) with an opening wedge angle in the beam direction, the beam entering one end surface (31) of the waveguide and emerging from the opposite end surface (32) adjacent to the first reflecting surface.

14. Arrangement according to Claim 5, **characterized in that** the first and second reflecting surfaces (17; 24) are oriented in such a way that, after the first reflecting surface (17), the individual beams (19) of the diodes are offset with respect to each other in a stair-like manner on an image plane (20), and **in that**, after the second reflecting surface (24), they are above or below each other on an image plane (25) in such a way that they form a continuous radiation field.

15. Arrangement according to one of Claims 9 to 11 and 13, **characterized in that** the waveguide or waveguides and the laser diodes (2) of the array (1) are arranged on a common substrate.

16. Arrangement according to Claim 15, **characterized in that** the substrate is made of silicon.
